Europäisches Patentamt

European Patent Office

Office européen des brevets

(19)

(11) EP 0 746 068 B1

(12) EUROPEAN PATENT SPECIFICATION

(45) Date of publication and mention
of the grant of the patent:
**22.12.1999 Bulletin 1999/51**

(51) Int Cl.[6]: **H01S 3/133**, H01S 3/043,
H01S 3/025

(21) Application number: **96111032.7**

(22) Date of filing: **30.03.1994**

(54) **Frequency stabilization method of semiconductor laser, frequency-stabilized light source and laser module**

Frequenzstabilisationsverfahren für Halbleiterlaser, frequenzstabilisierte Lichtquelle und Lasermodul

Méthode de stabilisation de la fréquence d'un laser à semi-conducteur, source de lumière stabilisée en fréquence, et module laser

(84) Designated Contracting States:
**DE FR GB**

(30) Priority: **31.05.1993 JP 12856993**

(43) Date of publication of application:
**04.12.1996 Bulletin 1996/49**

(62) Document number(s) of the earlier application(s) in
accordance with Art. 76 EPC:
**94105059.3 / 0 618 653**

(73) Proprietor: **NEC CORPORATION**
**Tokyo (JP)**

(72) Inventors:
• **Shiozawa, Takahiro**
**Minato-ku, Tokyo (JP)**
• **Henmi, Naoya**
**Minato-ku, Tokyo (JP)**

(74) Representative: **Glawe, Delfs, Moll & Partner**
**Patentanwälte**
**Postfach 26 01 62**
**80058 München (DE)**

(56) References cited:
**EP-A- 0 336 308** **US-A- 4 583 228**

• **IEEE TRANSACTIONS ON INSTRUMENTATION AND MEASUREMENT, vol. 36, no. 3, September 1987, NEW YORK, US, pages 789-796, XP002011118 S.YAMAGUCHI ET AL.: "Power Level Controlled Optical Sweep Oscillator Using a GaAs Semiconductor Laser"**
• **ELECTRONICS LETTERS, vol. 26, no. 6, 15 March 1990, STEVENAGE. GB, pages 405-406, XP000122770 M.S.NAKAMURA ET AL.: "Frequency-Stabilized LD Module with a Z-Cut Quartz Fabry-Perot Resonator for Coherent Communication"**
• **ELECTRONICS LETTERS, vol. 22, no. 10, 8 May 1986, STEVENAGE, GB, pages 553-554, XP002011119 H.TSUCHIDA ET AL.: "Wideband Frequency Scanning of a Stabilised Semiconductor Laser"**
• **JAPANESE JOURNAL OF APPLIED PHYSICS, vol. 19, no. 12, December 1980, TOKYO, JP, pages L721-L724, XP002011120 H.TSUCHIDA ET AL.: "Frequency Stability Measurement of Feedback Stabilized AlGaAs DH Laser"**
• **PATENT ABSTRACTS OF JAPAN vol. 12, no. 403 (E-674) [3250] , 26 October 1988 & JP-A-63 143888 (YOKOGAWA ELECTRIC), 16 June 1988,**
• **PATENT ABSTRACTS OF JAPAN vol. 14, no. 336 (E-0953), 19 July 1990 & JP-A-02 112295 (YOKOGAWA ELECTRIC), 24 April 1990,**

## Description

BACKGROUND OF THE INVENTION

### 1. Field of the Invention

The present invention relates to a semiconductor laser and more particularly, to a frequency stabilization method of a semiconductor laser, a frequency-stabilized light source and a semiconductor laser module used for the method.

### 2. Description of the prior art

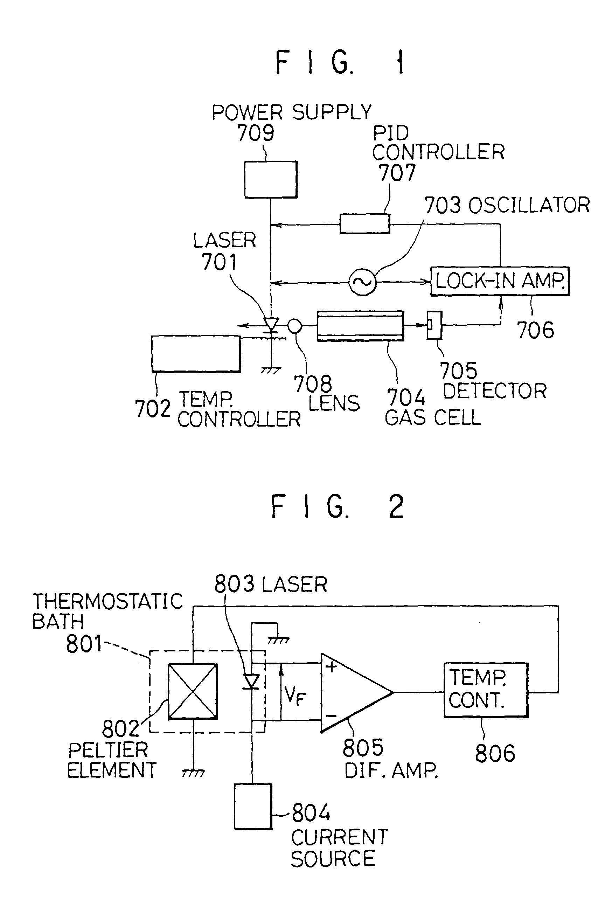

A conventional frequency stabilization method of a semiconductor laser is disclosed in the IEEE Journal of Quantum Electronics, Vol. 28, No. 1, Page 75, January 1992, in which an oscillation frequency of the laser is stabilized at an absorption line frequency of acetylene. Fig. 1 shows a functional block diagram of the conventional frequency stabilization method.

In Fig. 1, the ambient temperature of a semiconductor laser 701 is kept constant by a temperature controller 702. A DC power supply 709 supplies a driving current to the laser 701. The driving current is slightly modulated in frequency by a modulation signal outputted from an oscillator 703, resulting in frequency-modulated output light beams of the laser 701.

One of the output light beams of the laser 701 is emitted from a side face of the laser 701 and used for a given application. The other of the output light beams of the laser 701 is emitted from its opposite side face and goes through an optical lens system 708 to be injected into an acetylene ($C_2H_2$) gas cell 704. The light beam transmitted through the acetylene gas cell 704 is detected by a photodetector 705 to produce an electrical output signal. The electrical output signal is inputted into an lock-in amplifier 706 to be detected synchronously with the modulation frequency from the oscillator 703.

The lock-in amplifier 706 produces an electrical output signal proportional to a difference or error between the oscillation frequency of the laser 701 and one of absorption peak frequencies of acetylene in the cell 704. The electrical output signal from the amplifier 706 is fed-back to the driving current through a PID controller 707 in which a Proportional, Integral and Differential (PID) controlling method is employed. Thus, the laser 701 is controlled so that its oscillation frequency is kept to be in accordance with the absorption peak frequency of acetylene.

Due to high stability in the absorption peak frequency, the oscillation frequency of the semiconductor laser 701 can be highly stabilized or locked.

With the conventional frequency stabilization method shown in Fig. 1, to obtain the difference or error between the oscillation frequency and the absorption peak frequency, the gas cell 704 and the lock-in amplifier 706 are required, and the driving current is modulated in frequency to be injected into the laser 701. As a result, there arises disadvantages that large-sized and expensive setups or apparatuses are necessary for carrying out the method and no unmodulated output light beam can be obtained.

In the case of stabilizing the optical output power of the laser 701 during operation, there is another disadvantage that another photodetector is necessary in addition to the photodetector 705.

Further, there is still another disadvantage that stabilizable oscillation frequencies are restricted to the absorption peak frequencies of the gas in the cell 704, so that any or arbitrary oscillation frequencies cannot be selected.

Another conventional frequency stabilization method of a semiconductor laser is disclosed in the Japanese Non-Examined Patent Publication No. 64-74780, March 1989, in which a semiconductor laser temperature is detected from a forward voltage of the laser to keep the temperature constant. Fig. 2 shows a functional block diagram of the conventional frequency stabilization method.

In Fig. 2, a semiconductor laser 803 and a Peltier element 802 which generates and absorbs heat are arranged in a thermostatic bath 801. The laser 803 is driven by a constant current supplied from a DC current source 804. A differential amplifier 805 detects between input terminals or electrodes of the laser 803 its forward voltage drop $V_f$, and sends an electrical output signal proportional the voltage drop $V_f$ to a temperature controller 806.

In response to the output signal from the amplifier 805, the controller 806 increases or decreases a driving current for the Peltier element 801 to thereby keep the temperature of the laser 803 constant.

In general, the forward voltage drop $V_f$ of the semiconductor laser 803 is expressed as

$$V_f = \frac{k \cdot I_n (1 + \frac{I_f}{I_0})}{e \bullet T} \qquad (1)$$

where $I_0$ is the forward saturation current, $I_f$ is a driving or exciting current, T is the absolute temperature of the laser 803, e is the charge of an electron and k is the Boltzmann's constant.

To be seen from the equation (1), the forward voltage drop $V_f$ is inversely proportional to the absolute temperature T. Thus, the absolute temperature T of the laser 803 can be exactly measured from the voltage drop $V_f$.

The differential amplifier 805 produces an output signal relating to the absolute temperature T from the detected voltage drop $V_f$ and sends the signal to the temperature controller 806. In response to the signal, the controller 806 controls to keep the temperature of the laser 803 constant.

The oscillation frequency of the semiconductor laser 803 is decided by the absolute temperature T and driving current $I_f$, so that it can be seen that the oscillation frequency is stabilized if both of them are kept constant.

With the another conventional frequency stabilization method shown in Fig. 2, an error tends to arise in detection of the absolute temperature T through the differential amplifier 805 because the laser 803 has an leakage current and a recombination current without luminescence both of which increase with the passage of time, providing fluctuation or deviation in the absolute temperature T and driving current $I_f$.

As a result, there arises a disadvantage that the output light power and oscillation frequency of the laser 803 deviate from the given values, respectively.

In addition to the above methods, still another conventional frequency stabilization method of a semiconductor laser is disclosed in the Japanese Non-Examined Patent Publication No. 1-238083, September 1989. In the method, similar to the conventional method shown in Fig. 2, absorption peak frequencies of a gas is used.

Japanese Journal of Applied Physics, vol. 19, no. 12, Dec. 1980, p. L721-L724, shows a semiconductor laser stabilised at the resonant frequency of an external piezo-electrically modulated Fabry-Perot interferometer by controlling the temperature of the laser.

Electronics Letters, vol. 22, no. 10, 8 May 1986, p. 553-554, describes a semiconductor laser frequency locked to a Fabry-Perot interferometer by controlling the injection current to the laser. Wideband scanning of the stabilised laser frequency is achieved by changing the temperature of the interferometer.

SUMMARY OF THE INVENTION

An object of the present invention is to provide a frequency stabilization method of a semiconductor laser and a frequency-stabilized light source in which only a simple, compact and low-cost setup is necessary.

A further object of the present invention is to provide a frequency stabilization method of a semiconductor laser and a frequency-stabilized light source in which an output light power and an oscillation frequency of the semiconductor laser can be maintained even if the laser operates for a long period of time.

Another object of the present invention is to provide a frequency stabilization method of a semiconductor laser and a frequency-stabilized light source in which unmodulated light output can be obtained.

Still another object of the present invention is to provide a frequency stabilization method of a semiconductor laser and a frequency-stabilized light source in which both of the oscillation frequency and the output light power of the laser can be stabilized.

Still another object of the present invention is to provide a frequency-stabilized semiconductor laser module which enables the semiconductor laser to operate stably.

These objects are achieved by a frequency stabilisation method according to claim 1, a frequency-stabilized light source according to claim 8 and a semiconductor laser module according to claim 15. The further claims are related to different advantageous aspects of the present invention.

According to an aspect of the present invention, a frequency stabilization method of a semiconductor laser is provided, which includes the steps of injecting an output light beam from a semiconductor laser into an optical resonator, modulating a temperature of the optical resonator by a modulation signal, detecting a transmitted light beam through the optical resonator to produce a first output signal, synchronously detecting the first output signal with the modulation frequency to produce a second output signal, controlling an oscillation frequency of the semiconductor laser to keep the frequency at a given value using the second output signal as a signal showing an error in the oscillation frequency.

With the above frequency stabilization method of a semiconductor laser, no gas cell is required, so that only a simple, compact and low-cost setup is sufficient for the method.

Since the output light beam from the semiconductor laser itself is not modulated and the temperature of the optical resonator is modulated, an unmodulated output light beam can be obtained easily.

According to a further aspect of the present invention, a frequency-stabilized light source is provided, which enables the above method to be carried out.

The light source includes a semiconductor laser emitting an output light beam, an optical resonator into which the output light beam is injected, a modulator for modulating a temperature of the optical resonator by a modulation signal, a detector for detecting a transmitted light beam through the otpical resonator to produce a first output singal, a synchronous detector for synchronously detecting the first output signal with the modulation frequency to produce a second output signal, a controller for controlling an oscillation frequency of the semiconductor laser to keep the frequency at a given value using the second output signal as a signal showing an error in the oscillation frequency.

With the frequency-stabilized light source, the frequency method of the third aspect is carried out, so that the same effects or advantages as those in the third aspect can be obtained.

According to still another aspect of the present invention, a frequency-stabilized semiconductor laser module which can carry out the above method is provided.

The module includes a first heat sink whose temperature is controllable, a semiconductor laser mounted on the first heat sink, the semiconductor laser emitting an output light beam, a second heat sink whose temperature is controllable, an optical resonator mounted on the second heat sink, the output light beam being injected into the optical resonator to emit a transmitted light beam from the optical resonator, a detector for receiving the transmitted light beam to detect a power of the transmitted light beam, and a package for incorporating the first heat sink, the semiconductor laser, the second heat sink, the optical resonator and the detector.

With the above frequency-stabilized semiconductor laser module, the first heat sink, the semiconductor laser, the second heat sink, the optical resonator and the detector are incorporated in the package, so that the semiconductor laser can operate stably.

Additionally, because the first heat sink for the laser and the second heat sink for the optical resonator are separated, the temperatures of the first and second heat sinks can be set independently. As a result, there is an advantage that the peak frequency of the optical resonator and the oscillation frequency of the laser can be minutely adjusted independently with each other.

BRIEF DESCRIPTION OF THE DRAWINGS

Fig. 1 is a functional block diagram showing a conventional frequency stabilization method of a semiconductor laser.

Fig. 2 is a functional block diagram showing another conventional frequency stabilization method of a semiconductor laser.

Fig. 3 is a functional block diagram of a frequency-stabilized light source according to a first example not in accordance with the invention.

Fig. 3A schematically shows a cross section of a semiconductor laser used in the light source shown in Fig. 3.

Fig. 4 is a functional block diagram of a frequency-stabilized light source according to a second example not in accordance with the present invention.

Fig. 5 is a functional block diagram of a frequency-stabilized light source according to a first embodiment of the present invention.

Fig. 6 is a functional block diagram of a frequency-stabilized light source according to a second embodiment of the present invention.

Fig. 7 is a functional block diagram of a frequency-stabilized light source according to a third embodiment of the present invention.

DETAILED DESCRIPTION OF THE PREFERRED EMBODIMENTS

Preferred embodiments of the present invention will be described below while referring to the drawings attached.

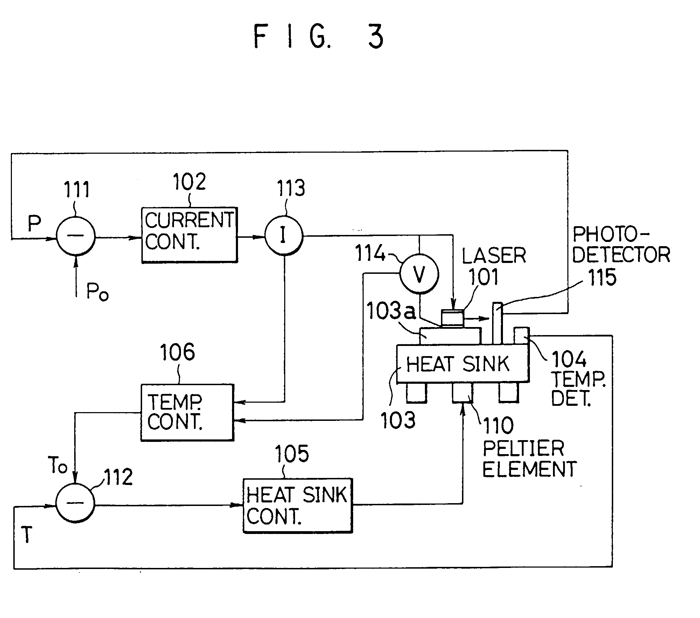

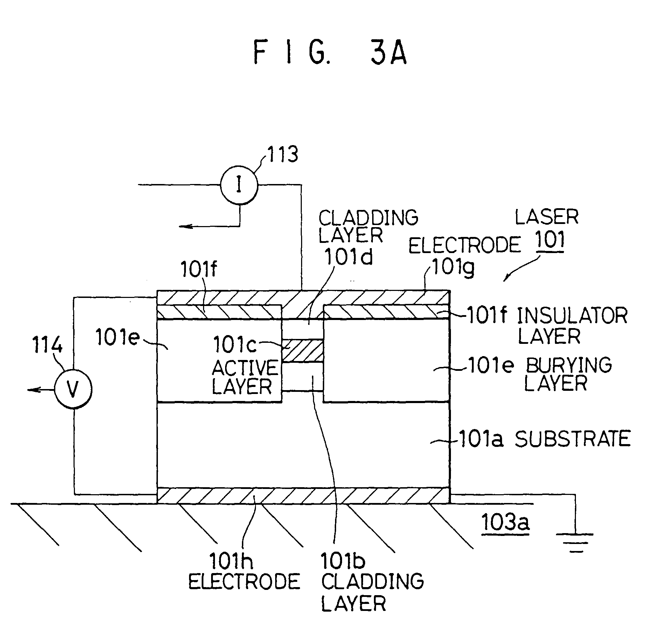

In Fig. 3, which shows a frequency-stabilized light source according to a first example not in accordance with the invention, a semiconductor laser 101 is mounted on a heat sink 103 through a subcarrier 103a.

A photodetector 115 fixed on the heat sink 103 receives an output light beam of the laser 101 to detect its power and outputs an electrical signal corresponding to the detected power P to a first subtractor 111.

The first subtractor 111 produces by subtraction a difference between the detected power P and the predetermined reference power $P_0$ and outputs an electrical signal corresponding to the power difference thus produced to a current controller 102. In response to this signal, the current controller 102 controls to increase or decrease a driving current for the laser 101 in order to keep or stabilize the power of the output light beam at $P_0$.

A current detector 113 is arranged in a current path between the current controller 102 and the laser 101 to detect the driving current. The current detector 113 outputs an electric signal corresponding to the driving current thus detected to a temperature controller 106. Thus, the driving current is always monitored by the temperature controller 106 during operation.

A voltage detector 114 is electrically connected between input terminals of the laser 101 to detect the voltage therebetween. The voltage detector 114 outputs an electric signal corresponding to the inter-terminal voltage thus detected to the temperature controller 106. Thus, the forward voltage of the laser 101 is always monitored by the temperature controller during operation.

The temperature controller 106 carries out a mathematical operation to get the consumption power of the laser 101 based on the output signals from the current and voltage detectors 113 and 114. Then, the controller 106 increases or decreases the reference temperature $T_0$ of the heat sink 103 based on the result of the operation and sends an electric signal corresponding to the reference temperature $T_0$ to a second subtractor 112.

A temperature detector 104 fixed on the heat sink 103 detects the temperature of the heat sink 103. The detector 104 produces an electric signal corresponding to the detected temperature T to send the signal to the second subtractor 112.

The second subtractor 112 produces by subtraction a difference between the detected temperature T and the reference temperature $T_0$ and outputs an electrical signal corresponding to the temperature difference thus produced to a heat sink controller 105. In response to this signal, the heat sink controller 105 increases or decreases the temperature of the heat sink 103 in order to keep or stabilize the temperature at $T_0$.

The temperature control by the heat sink controller 105 is carried out using Peltier elements 110 attached to the heat sink 103. Since the Peltier elements 110 generate or absorb heat depending upon its driving current, the temperature of the heat sink 103 can be increased or decreased precisely by the elements 110.

Fig. 3A shows a cross section of the semiconductor laser 101 used in the light source shown in Fig.

3. In Fig. 3A, on the surface of a semiconductor substrate 101a, a strip portion formed of an active layer 101c and upper and lower cladding layers 101d and 101b respectively disposed on upper and lower sides of the active layer 101c. The strip portion is bounded on its each side by a pair of burying layers 101e formed on the surface of the substrate 101a.

A pair of insulator layers 101f are formed on the surfaces of the pair of the burying layers 101e, respectively. An upper electrode or terminal 101g is formed on the surfaces of the insulator layers 101f and the upper cladding layer 101d. A lower electrode or terminal 101h is formed on the back surface of the substrate 101a. The laser 101 is fixed to the subcarrier 103a through the lower electrode 101h.

The pair of the burying layers 101e act as current blocking layers for narrowing the driving current path.

The current detector 113 is electrically connected to the upper electrode 101g and the voltage detector 114 is electrically connected to the upper and lower electrodes 101g and 101h.

Next, the frequency stabilization operation of the semiconductor laser 101 is described below.

The semiconductor laser 101 tends to show a drift or deviation in oscillation frequency in a long period of time when the driving current is controlled so that the output light power of the laser 101 is kept constant and at the same time, the controlling current for the Peltier elements 110 is controlled so that the temperature of the heat sink 103 is kept constant.

It is considered that the drift or deviation in oscillation frequency is caused by change in percentage which contributes the laser oscillation within the total driving current injected into the laser 101. The change in percentage contributing laser oscillation is considered to be caused by (a) increase in leakage current due to deterioration of the current blocking layers or the pair of the burying layers 101e, and by (b) increase in recombination current without luminescence due to deterioration of the active layer 101c.

For example, when both of the output light power and the temperature are kept constant, the driving current percentage contributing laser oscillation tends to decrease, and the driving current increases to compensate the percentage decrease. Thus, the temperature of the active layer 101c rises in response to the increase in the driving current and as a result, the oscillation frequency of the laser 101 will drift toward the lower frequency side.

The drift $\Delta f$ of the oscillation frequency can be expressed as follows:

It is hardly considered that because an optical loss within the semiconductor laser 101 changes during operation in the long period of time, the carrier density in the laser 101 is kept substantially constant during operation and as a result, the oscillation frequency is not affected by the optical loss. Therefore, it is considered that the frequency change or drift $\Delta f$ is caused by the temperature change $\Delta T$ of the active layer 101c.

Under the first order approximation, the frequency change $\Delta f$ can be expressed as

$$\Delta f = \frac{\partial f}{\partial T} \bullet \Delta T \qquad (2)$$

The equation (2) means that the frequency change $\Delta f$ is zero if the temperature of the active layer 101c is constant, that is, the temperature difference $\Delta T$ is zero.

The temperature of the semiconductor laser 101 can be controlled to be kept constant by the heat sink controller 105, however, there arises a temperature difference between the active layer 101c and the heat sink 103 because of heat resistance between the active layer 101c and the temperature detector 104 when the consumption power of the laser 101 changes.

The temperature change $\Delta T$ of the active layer 101c is expressed as

$$\Delta T = \theta \bullet \Delta W + \Delta T_0 \qquad (3)$$

where $\Delta W$ is the consumption power change of the active layer 101c, $\theta$ is the heat resistance between the active layer 101c and the temperature detector 104 and $\Delta T_0$ is the change of the reference temperature of the heat sink 103.

Consequently, it is seen that the temperature change $\Delta T_0$ can be cancelled if the following equation (4) is established, resulting in a stabilized oscillation frequency.

$$\Delta T_0 = -\theta \bullet \Delta W \qquad (4)$$

Here, the total driving current $i_t$ and the forward voltage v between the input electrodes 101g and 101h can be expressed as the following equations (5a) and (5b) using the initial, total driving current $i_{t0}$, the initial forward voltage $v_0$, the change $\Delta i_t$ of the total driving current $i_t$, and the change $\Delta v$ of the forward voltage.

$$i_t = i_{t0} + \Delta i_t \qquad (5a)$$

$$v = v_0 + \Delta v \qquad (5b)$$

From the equations (5a) and (5b), the consumption power change $\Delta W$ of the active layer 101c can be expressed as

$$\Delta W = W - W_0 = i_t \bullet v - i_{t0} \bullet v_0$$

$$= \Delta i_t \bullet v_0 + it_0 \bullet \Delta v + \Delta i_t \bullet \Delta v \qquad (6)$$

The reference temperature $T_0$ of the heat sink 103 is controlled by the heat sink controller 105 so that the consumption power change $\Delta W$ expressed by the equation (6) is cancelled.

The temperature controller 106 calculates in value the consumption power change $\Delta W$ using the equations (4) and (6) based on the electric signals from the current and voltage detectors 113 and 114. Then, the controller 106 adjusts in value the reference temperature $T_0$ to cancel the calculated value of the consumption power change $\Delta W$.

As described above, with the light source according to the first example, the current controller 102 controls the driving current for the semiconductor laser 101 so that the output light power of the laser 101 is kept constant, and at the same time, the temperature controller 106 and the heat sink controller 105 control the reference temperature $T_0$ of the heat sink 103 so that the temperature change of the active layer 101c is cancelled.

As a result, the oscillation frequency of the laser 101 can be stabilized because of no oscillation frequency drift due to electrical and optical characteristic changes of the laser 101 with passage of time.

Additionally, no gas cell and no synchronous detection means such as a lock-in amplifier are required, so that there arises an advantage that a simple, compact and low-cost setup is sufficient for the light source.

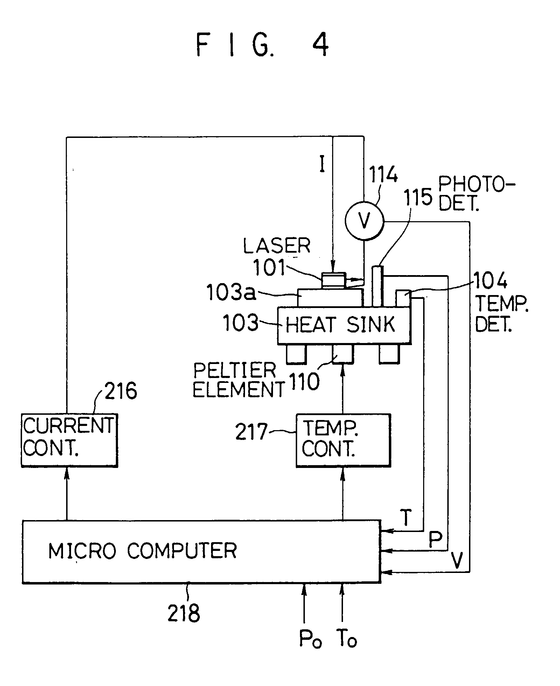

Fig.4 shows a frequency-stabilized light source according to a second example not in accordance with the present invention. In Fig. 4, the same reference numerals as those in Fig. 3 are attached to the corresponding elements for the sake of simplification of description and illustration.

A current control circuit 216 for controlling the driving current I for the semiconductor laser 101, a temperature control circuit 217 for controlling the temperature of the heat sink 103, and a micro computer 21 for controlling the circuits 216 and 217 are provided instead of the current controller 102, the temperature controller 106 and the heat sink controller 105 in Fig. 3.

The temperature detector 104 sends an electric signal corresponding to the detected temperature T of the heat sink 103 to the micro computer 218. The photodetector 115 sends an electric signal corresponding to the detected light power P of the laser 101 to the micro computer 218. The voltage detector 114 sends an electric signal corresponding to the detected voltage V of the laser 101 to the micro computer 218.

The micro computer 218 is storing data relating the reference power $P_0$ and the reference temperature $T_0$ in advance. The computer 218 calculates data using the signal about the output light power P from the photodetector 115 and sends the data to the current control circuit 216. In response to the data thus sent, the current control circuit 216 controls to supply the driving current to the semiconductor laser 101, so that the output light power from the laser 101 is kept constant.

On the other hand, the computer 218 calculates data using the signals about the forward voltage V from the voltage detector 114 and the temperature T from the temperature detector 104, and sends the data to the temperature control circuit 217. In response to the data thus sent, the temperature control circuit 217 controls to supply the driving current to the Peltier elements 110, so that the reference temperature $T_0$ of the heat sink 103 is adjusted in order to cancel the temperature change of the active layer 101c.

Therefore, in the second example, the same effects as those the first example can be obtained. Additionally, there is an advantage that the configuration or setup can be made simpler than that of the first example because of the micro computer 218.

[First Embodiment]

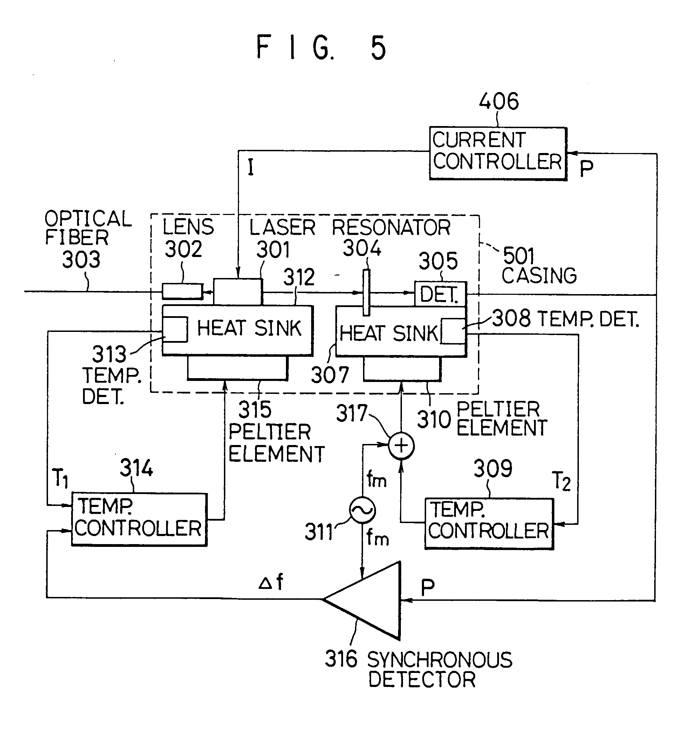

Fig.5 shows a frequency-stabilized light source according to a first embodiment of the present invention.

In Fig. 5, a semiconductor laser 301, which is fixed on a first heat sink 312, emits an output light beam from its one side face and the emitted light beam is injected into an optical fiber 303 optically coupled with the laser 101 through a lens system 302.

A first temperature detector 313 and a first Peltier element 315 are fixed to the first heat sink 312. The detector 313 and the element 315 act to control the temperature of the first heat sink 312 together with a first temperature controller 314, providing the temperature control of the laser 301.

The first temperature controller 314 receives an electric signal about the temperature $T_1$ of the first heat sink 312 from the first temperature detector 313. On the other hand, the first temperature controller 314 receives an electric signal about the frequency difference or drift $\Delta f$ from a synchronous detector 316. Based on the signals thus received, the controller 314 controls a driving current for the first Peltier element 315 to increase or decrease the temperature of the first heat sink 312.

Thus, the temperature $T_1$ of the semiconductor laser 301 is controlled to be kept constant.

Another output light beam of the laser 301 is emitted from its opposite side face and is injected into an optical resonator 304 fixed on a second heat sink 307. The optical resonator 304 is composed of, for example, an optical filter formed of a dielectric multilayer film, a Fabry-Perot etalon or the like. The second heat sink 307 is arranged apart from and adjacent to the first heat sink 312.

The light beam transmitted through the optical resonator 304 goes into a photodetector 305 fixed on the second heat sink 307. The photodetector 305 produces an electric signal corresponding to the detected power P of the light beam and sends the signal to a current controller 406 and the synchronous detector 316.

The current controller 406 controls a driving current I for the laser 301 so that the average output from the photodetector 305 is kept constant.

A second temperature detector 308 and a second Peltier element 310 are fixed to the second heat sink 307. The detector 308 and the element 310 act to control the temperature of the second heat sink 307 together with a second temperature controller 309, providing the temperature control of the optical resonator 304.

The second temperature controller 309 receives an electric signal corresponding to the detected temperature $T_2$ of the second heat sink 307 from the second temperature detector 308. Based on the signal thus received, the controller 309 controls a driving current for the second Peltier element 310 to increase or decrease the temperature of the second heat sink 307.

The output signal from the second temperature controller 309 is slightly modulated by a modulation signal and is sent to the second Peltier element 310. The modulation signal is supplied from an oscillator 311 and whose frequency is $f_m$.

Thus, the temperature of the optical resonator 304 is modulated by the modulation signal and at the same time, the temperature $T_2$ is controlled so that the time average of the temperature $T_2$ is kept constant.

The synchronous detector 316 detects the output signal from the photodetector 305 synchronously with the modulation signal from the oscillator 311. The optical resonator 304 such as a dielectric multilayer film filter or a Fabry-Perot etalon has a peak frequency for the transmitted light beam, which can be approximated by the Lorentz function or Gauss function. In addition, an electric output signal from the synchronous detector 316 has a waveform equal to the primary-differentiated waveform of the transmitted light beam at the peak frequency, so that the output signal is approximately proportional to the difference $\Delta f$ between the frequency of the output light beam injected into the optical resonator 304 and the peak frequency of the transmitted light beam through the resonator 304. This means that the electrical output signal from the synchronous detector 316 is available as a signal showing the frequency difference or error $\Delta f$.

The output signal from the synchronous detector 316 is sent to the first temperature controller 314. Then, the temperature of the semiconductor laser 301 is controlled by the controller 314 so that the oscillation frequency of the output light beam from the laser 301 is kept in accordance with the peak frequency of the transmitted light beam through the optical resonator 304, As a result, the oscillation frequency of the output light from the laser 301 is kept constant.

In the first embodiment, similar to the first and second examples, since no gas cell is necessary, a simple, compact and low-cost light source can be realized. Since the driving current is not modulated, an unmodulated output light can be provided easily.

Also, the semiconductor laser 301, the optical lens system 302, the optical resonator 304, the photodetector 305, the first and second heat sinks 312 and 307, the first and second temperature detectors 313 and 308, and the first and second Peltier elements 315 and 310 are incorporated into a casing 501, providing a semiconductor laser module. Therefore, there is an advantage of more stable operation and more compact size.

In addition, stabilization in both oscillation frequency and output light power can be realized only by the photodetector 305.

[Second Embodiment]

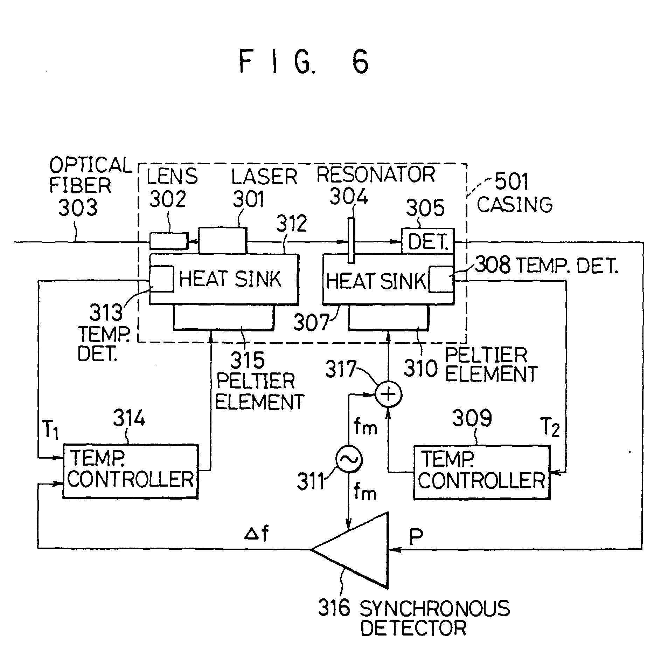

Fig.6 shows a frequency-stabilized light source according to a second embodiment, which is the same configuration as that of the first embodiment excepting that the current controller 406 in the first embodiment is omitted.

In the fourth embodiment, in response to the detected power P of the light beam transmitted through the optical resonator 304, the photodetector 305 produces an electric signal corresponding to the detected power P and sends the signal only to the synchronous detector 316. The driving current I for the laser 301 is not controlled because of no current controller.

Since the driving current I for the semiconductor laser 301 is not controlled, the power of the output light beam from the laser 301 does not necessarily stabilized, however, there is an advantage that the configuration becomes simpler than that of the first embodiment.

[Third Embodiment]

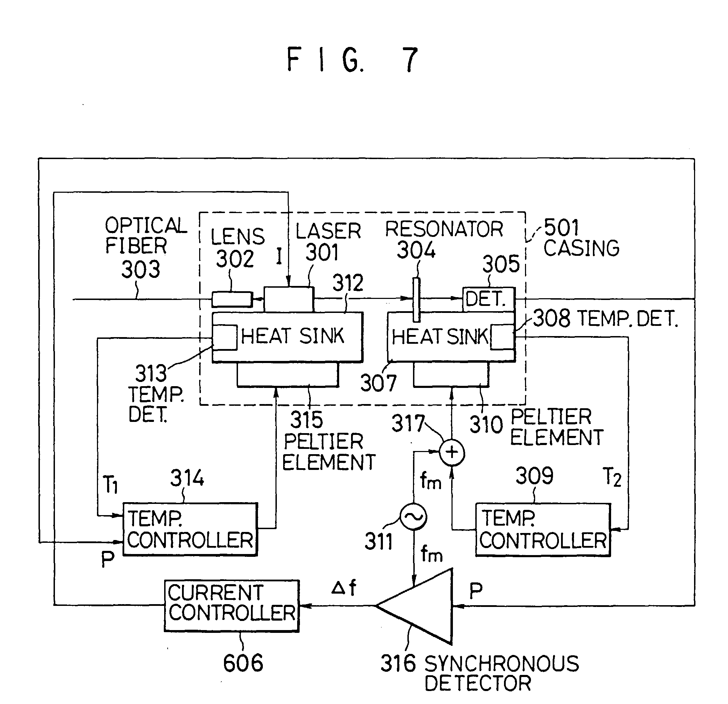

Fig.7 shows a frequency-stabilized light source according to a third embodiment, in which the temperature of the semiconductor laser 301 is controlled so that the output light power of the laser 301 is kept constant and the driving current for the laser 301 is controlled so that the oscillation frequency of the output light beam is kept constant.

In Fig. 7, the same reference numerals as those in Fig. 5 are attached to the corresponding elements for the sake of simplification of description and illustration.

Different from the first embodiment in Fig. 5, a current controller 606 is arranged between the synchronous detector 316 and the semiconductor laser 301.

The first temperature controller 314 receives an electric signal corresponding to the temperature $T_1$ of the first heat sink 312 from the first temperature detector 313. On the other hand, the first temperature controller 314 receives an electric signal corresponding to the output light power P from the photodetector 305. Based on the signals thus received, the controller 314 controls the driving current for the first Peltier element 315 to increase or decrease the temperature of the first heat sink 312.

Thus, the output light power of the semiconductor laser 301 is controlled to be kept constant.

The electrical output signal corresponding the detected power P of the output light, which is outputted from the photodetector 305, is sent to the synchronous detector 316. The detector 316 detects the signal thus sent synchronously with the modulation frequency $f_m$ from the oscillator 311 and produces an electric signal proportional to the frequency difference $\Delta f$. The signal thus produced is then sent to the current controller 606.

The output signal from the second temperature controller 309 is slightly modulated by a modulation signal whose frequency is $f_m$ and is sent to the second Peltier element 310.

The current controller 606 controls a driving current I for the laser 301 so that the oscillation frequency of the laser 301 is kept constant.

Thus, the temperature of the optical resonator 304 is modulated by the modulation signal from the oscillator 311 and at the same time, the temperature is controlled so that the time average of the temperature is kept constant.

In the third embodiment, the same effects or advantages as those in the first embodiment can be obtained.

In the present invention, any control means such as analog control means using the PID control method, digital control means using micro computers or the like can be employed as the controllers above described.

It is needless to say that the present invention is not restricted to the above first to third embodiments, and any other variations can be made within the scope of the claims.

## Claims

1. A frequency stabilization method for a semiconductor laser (301), said method comprising the steps of:

    injecting an output light beam from a semiconductor laser (301) into an optical resonator (304);
    modulating the temperature of said optical resonator (304) by a modulation signal;
    detecting the transmitted light beam through said optical resonator (304) to produce a first output signal;
    synchronously detecting said first output signal and said modulation frequency to produce a second output signal;

    controlling the oscillation frequency of said semiconductor laser (301) to keep said frequency at a given value using said second output signal as a signal showing an error in said oscillation frequency.

2. A frequency stabilization method of a semiconductor laser (301) as claimed in claim 1, wherein said oscillation frequency of said semiconductor laser (301) is controlled to be in accordance with the peak frequency of said optical resonator (304) in said step of controlling an oscillation frequency.

3. A frequency stabilization method of a semiconductor laser (301) as claimed in claim 1, wherein said semiconductor laser (301) is mounted on a first heat sink (312) and is controlled to have a constant temperature, and wherein said optical resonator (304) is mounted on a second heat sink (307) and said temperature of said optical resonator (304) is modulated through said second heat sink (307).

4. A frequency stabilization method of a semiconductor laser (301) as claimed in claim 1, wherein the driving current for said semiconductor laser (301) is controlled so that an output light power from said laser (301) is kept constant.

5. A frequency stabilization method of a semiconductor laser as claimed in claim 1, wherein the temperature of said semiconductor laser (301) is controlled so that an output light power from said laser (301) is kept constant.

6. A frequency stabilization method of a semiconductor laser (301) as claimed in claim 1, wherein the driving current for said semiconductor laser (301) is controlled so that said oscillation frequency of said laser (301) is kept at a given value.

7. A frequency stabilization method of a semiconductor laser (301) as claimed in claim 1, wherein the temperature of said semiconductor laser (301) is controlled so that said oscillation frequency of said laser (301) is kept at a given value.

8. A frequency-stabilized light source comprising:

    a semiconductor laser (301) emitting an output light beam;
    an optical resonator (304) into which said output light beam is injected;
    a modulator (309) for modulating the temperature of said optical resonator by a modulation signal;
    a detector (305) for detecting the transmitted light beam through said optical resonator (304) to produce a first output signal;

a synchronous detector (316) for synchronously detecting said first output signal and said modulation frequency to produce a second output signal;

a controller (314) for controlling the oscillation frequency of said semiconductor laser to keep said frequency at a given value using said second output signal as a signal showing an error in said oscillation frequency.

9. A frequency-stabilized light source as claimed in claim 8, wherein said oscillation frequency of said semiconductor laser (301) is controlled to be in accordance with the peak frequency of said optical resonator (304).

10. A frequency-stabilized light source as claimed in claim 8, wherein said semiconductor laser (301) is mounted on a first heat sink (312) and is controlled to have a constant temperature, and wherein said optical resonator (304) is mounted on a second heat sink (307) and said temperature of said optical resonator (304) is modulated through said second heat sink (307).

11. A frequency-stabilized light source as claimed in claim 8, wherein the driving current for said semiconductor laser (301) is controlled so that an output light power from said laser (301) is kept constant.

12. A frequency-stabilized light source as claimed in claim 8, wherein the temperature of said semiconductor laser (301) is controlled so that an output light power from said laser (301) is kept constant.

13. A frequency-stabilized light source as claimed in claim 8, wherein the driving current for said semiconductor laser (301) is controlled so that said oscillation frequency of said laser (301) is kept at a given value.

14. A frequency-stabilized light source as claimed in claim 8, wherein the temperature of said semiconductor laser (301) is controlled so that said oscillation frequency of said laser (301) is kept at a given value.

15. A semiconductor laser module comprising:

a first heat sink (312) whose temperature is controllable;
a semiconductor laser (301) mounted on said first heat sink (312);
said semiconductor laser (301) emitting an output light beam; a modulation signal source (311) emitting a modulation signal;
a second heat sink (307) whose temperature is modulated by said modulation signal;

an optical resonator (304) mounted on said second heat sink (307);
said output light beam being injected into said optical resonator to emit a transmitted light beam from said optical resonator (304);
a detector (305) for receiving said transmitted light beam to detect a power of said transmitted light beam; and
a package (501) for incorporating said first heat sink, said semiconductor laser, said second heat sink, said optical resonator and said detector.

16. A semiconductor laser module as claimed in claim 15,

wherein the temperature of said optical resonator (304) is modulated by said modulation signal;
the transmitted light beam through said optical resonator (304) is used to produce a first output signal;
the power of said transmitted light beam is controlled to be kept constant based on said first output signal;
said first output signal is synchronously detected with said modulation frequency to produce a second output signal; and
the oscillation frequency of said semiconductor laser (301) is controlled to keep said frequency at a given value using said second output signal as a signal showing an error in said oscillation frequency.

17. A semiconductor laser module as claimed in claim 16, wherein said oscillation frequency of said semiconductor laser (301) is controlled to be in accordance with a peak frequency of said optical resonator (304) in said step of controlling an oscillation frequency.

18. A semiconductor laser module as claimed in claim 15, wherein said semiconductor laser (301) is controlled to have a constant temperature through said first heat sink (312) and said

optical resonator (304) is modulated through said second heat sink (307).

**Patentansprüche**

1. Verfahren zur Frequenzstabilisierung für einen Halbleiterlaser (301), wobei das Verfahren die Schritte aufweist:

Injizieren eines Ausgabelichtstrahls von einem Halbleiterlaser (301) in einen optischen Resonator (304),

Modulieren der Temperatur des optischen Resonators (304) durch ein Modulationssignal,

Detektieren des durch den optischen Resonator (304) übertragenen Lichtstrahls, um ein erstes Ausgabesignal zu erzeugen,

synchrones Detektieren des ersten Ausgabesignals und der Modulationsfrequenz, um ein zweites Ausgabesignal zu erzeugen,

Steuern der Oszillationsfrequenz des Halbleiterlasers (301), um die Frequenz auf einem gegebenen Wert zu halten, unter Verwendung des zweiten Ausgabesignals als ein Signal, das einen Fehler in der Oszillationsfrequenz zeigt.

2.  Verfahren zum Stabilisieren der Frequenz eines Halbleiterlasers (301) nach Anspruch 1, wobei im Schritt des Steuerns der Oszillationsfrequenz die Oszillationsfrequenz des Halbleiterlasers (301) gesteuert wird, um in Übereinstimmung mit der Spitzenfrequenz des optischen Resonators (304) zu sein.

3.  Verfahren zur Frequenzstabilisierung eines Halbleiterlasers (301) nach Anspruch 1, wobei der Halbleiterlaser (301) auf einer ersten Wärmesenke (312) montiert ist und gesteuert wird, um eine konstante Temperatur zu haben, und wobei der optische Resonator (304) auf einer zweiten Wärmesenke (307) montiert ist und die Temperatur des optischen Resonators (304) über die zweite Wärmesenke (307) moduliert wird.

4.  Verfahren zur Frequenzstabilisierung eines Halbleiterlases (301) nach Anspruch 1, wobei der Treiberstrom für den Halbleiterlaser (301) so gesteuert wird, daß die Lichtausgabeleistung des Lasers (301) konstant gehalten wird.

5.  Verfahren zur Frequenzstabilisierung eines Halbleiterlasers nach Anspruch 1, wobei die Temperatur des Halbleiterlasers (301) so gesteuert wird, daß die Lichtausgabeleistung des Lasers (301) konstant gehalten wird.

6.  Verfahren zur Frequenzstabilisierung eines Halbleiterlasers (301) nach Anspruch 1, wobei der Treiberstrom für den Halbleiterlaser (301) so gesteuert wird, daß die Oszillationsfrequenz des Lasers (301) auf einem gegebenen Wert gehalten wird.

7.  Verfahren zur Frequenzstabilisierung eines Halbleiterlasers (301) nach Anspruch 1, wobei die Temperatur des Halbleiterlasers (301) so gesteuert wird, daß die Oszillationsfrequenz des Lasers (301) auf einem gegebenen Wert gehalten wird.

8.  Frequenzstabilisierte Lichtquelle mit:

einem Halbleiterlaser (301), der einen Ausgablichtstrahl erzeugt,

einem optischen Resonator (304), in den der Ausgabelichtstrahl injiziert wird,

einem Modulator (309) zum Modulieren der Temperatur des optischen Resonators durch ein Modulationssignal,

einem Detektor (305) zum Detektieren des durch den optischen Resonator (304) erzeugten übertragenen Lichtstrahls, um ein erstes Ausgabesignal zu erzeugen,

einem Synchrondetektor (316) zum synchronen Detektieren des ersten Ausgabesignals und der Modulationsfrequenz, um ein zweites Ausgabesignal zu erzeugen,

einer Steuerung (314) zum Steuern der Oszillationsfrequenz des Halbleiterlasers, um die Frequenz auf einem gegebenen Wert zu halten, unter Verwendung des zweiten Ausgabesignals als ein Signal, das einen Fehler in der Oszillationsfrequenz zeigt.

9.  Frequenzstabilisierte Lichtquelle nach Anspruch 8, wobei die Oszillationsfrequenz des Halbleiterlasers (301) so gesteuert wird, daß sie in Übereinstimmung mit der Spitzenfrequenz des optischen Resonators (304) ist.

10. Frequenzstabilisierte Lichtquelle nach Anspruch 8, wobei der Halbleiterlaser (301) auf einer ersten Wärmsenke (312) montiert ist und gesteuert wird, um eine konstante Temperatur zu haben, und wobei der optische Resonator (304) auf einer zweiten Wärmesenke (307) montiert ist, wobei die Temperatur des optischen Resonators (304) über die zweite Wärmesenke (307) moduliert wird.

11. Frequenzstablisierte Lichtquelle nach Anspruch 8, wobei der Treiberstrom für den Halbleiterlaser (301) so gesteuert wird, daß eine Lichtausgabeleistung von dem Laser (301) konstant gehalten wird.

12. Frequenzstabilisierte Lichtquelle nach Anspruch 8, wobei die Temperatur des Halbleiterlasers (301) so gesteuert wird, daß die Lichtausgabeleistung des Lasers (301) konstant gehalten wird.

13. Frequenzstabilisierte Lichtquelle nach Anspruch 8, wobei der Treiberstrom für den Halbleiterlaser (301) so gesteuert wird, daß die Oszillationsfrequenz des Lasers (301) auf einem gegebenen Wert gehalten wird.

14. Frequenzstabilisierte Lichtquelle nach Anspruch 8, wobei die Temperatur des Halbleiterlasers (301) so gesteuert wird, daß die Oszillationsfrequenz des Lasers (301) auf einem gegebenen Wert gehalten wird.

**15.** Halbleiterlasermodul mit:

einer ersten Wärmesenke (312), deren Temperatur steuerbar ist,

einem Halbleiterlaser (301), der auf der ersten Wärmesenke (312) montiert ist,

wobei der Halbleiterlaser (301) einen lichtausgabestrahl emittiert,

einer Modulationssignalquelle (311), die ein Modulationssignal abgibt,

einer zweiten Wärmesenke (307), deren Temperatur durch das Modulationssignal moduliert wird,

einem optischen Resonator (304), der auf der zweiten Wärmesenke (307) montiert ist,

wobei der Lichtausgabestrahl in den optischen Resonator injiziert wird, um einen übertragenen Lichtstrahl von dem optischen Resonator (304) zu emittieren,

einem Detektor (305) zum Empfangen des übertragenen Lichtstrahls zur Erfassung der Leistung des übertragenen Lichtstrahls, und

einer Packung (501) zum Aufnehmen der ersten Wärmesenke des Halbleiterlasers, der zweiten Wärmesenke, des optischen Resonators und des Detektors.

**16.** Halbleiterlasermodul nach Anspruch 15, wobei die Temperatur des optischen Resonators (304) durch das Modulationssignal moduliert wird,

wobei der durch den optischen Resonator (304) übertragene Lichtstrahl verwendet wird, um ein erstes Ausgabesignal zu erzeugen,

wobei die Leistung des übertragenen Lichtstrahls basierend auf dem ersten Ausgabsignal gesteuert wird, um konstant gehalten zu werden,

das erste Ausgabesignal synchron mit der Modulationsfrequenz detektiert wird, um ein zweites Ausgabesignal zu erzeugen, und

die Oszillationsfrequenz des Halbleiterlasers (301) gesteuert wird, um die Frequenz auf einem gegebenen Wert zu halten, unter Verwendung des zweiten Ausgabesignal als ein Signal, das einen Fehler in der Oszillationsfrequenz zeigt.

**17.** Halbleiterlasermodul nach Anspruch 16, wobei im Schritt des Steuerns der Oszillationsfrequenz die Oszillationsfrequenz des Halbleiterlasers (301) gesteuert wird, um in Übereinstimmung mit einer Spitzenfrequenz des optischen Resonators (304) zu sein.

**18.** Halbleiterlasermodul nach Anspruch 15, wobei der Halbleiterlaser (301) über die erste Wärmesenke (312) gesteuert wird, um eine konstante Temperatur zu haben, und

wobei der optische Resonator (304) über die zweite Wärmesenke (307) moduliert wird.

## Revendications

**1.** Procédé de stabilisation de fréquence pour un laser à semiconducteur (301), ledit procédé comprenant les étapes suivantes :

injection d'un faisceau de lumière de sortie en provenance d'un laser à semiconducteur (301) dans un résonateur optique (304) ;

modulation de la température dudit résonateur optique (304) par un signal de modulation ;

détection du faisceau de lumière transmis à travers ledit résonateur optique (304) pour produire un premier signal de sortie ;

détection synchrone dudit premier signal de sortie et de ladite fréquence de modulation pour produire un second signal de sortie ;

commande de la fréquence d'oscillation dudit laser à semiconducteur (301) pour conserver ladite fréquence à une valeur donnée en utilisant ledit second signal de sortie en tant que signal représentant une erreur dans ladite fréquence d'oscillation.

**2.** Procédé de stabilisation de fréquence d'un laser à semiconducteur (301) selon la revendication 1, dans lequel ladite fréquence d'oscillation dudit laser à semiconducteur (301) est commandée en fonction de la fréquence de crête dudit résonateur optique (304) dans ladite étape de commande de fréquence d'oscillation.

**3.** Procédé de stabilisation de fréquence d'un laser à semiconducteur (301) selon la revendication 1, dans lequel ledit laser à semiconducteur (301) est monté sur un premier puits de chaleur (312) et est commandé pour avoir une température constante, et dans lequel ledit résonateur optique (304) est monté sur un second puits de chaleur (307) et ladite température dudit résonateur optique (304) est modulée par l'intermédiaire dudit second puits de chaleur (307).

**4.** Procédé de stabilisation de fréquence d'un laser à semiconducteur (301) selon la revendication 1, dans lequel le courant de pilotage pour ledit laser à semiconducteur (301) est commandé de sorte qu'une puissance de lumière de sortie en provenance dudit laser (301) est conservée constante.

**5.** Procédé de stabilisation de fréquence d'un laser à semiconducteur selon la revendication 1, dans lequel la température dudit laser à semiconducteur (301) est commandée de sorte qu'une puissance de lumière de sortie en provenance dudit laser (301) est conservée constante.

6. Procédé de stabilisation de fréquence d'un laser à semiconducteur (301) selon la revendication 1, dans lequel le courant de pilotage pour ledit laser à semiconducteur (301) est commandé de sorte que ladite fréquence d'oscillation dudit laser (301) est conservée à une valeur donnée.

7. Procédé de stabilisation de fréquence d'un laser à semiconducteur (301) selon la revendication 1, dans lequel la température dudit laser à semiconducteur (301) est commandée de sorte que ladite fréquence d'oscillation dudit laser (301) est conservée à une valeur donnée.

8. Source de lumière à fréquence stabilisée comprenant :

   un laser à semiconducteur (301) émettant un faisceau de lumière de sortie ;
   un résonateur optique (304) dans lequel ledit faisceau de lumière de sortie est injecté ;
   un modulateur (309) pour moduler la température dudit résonateur optique par un signal de modulation ;
   un détecteur (305) pour détecter le faisceau de lumière transmis à travers ledit résonateur optique (304) pour produire un premier signal de sortie ;
   un détecteur synchrone (316) pour détecter de manière synchrone ledit premier signal de sortie et ladite fréquence de modulation pour produire un second signal de sortie ;
   une unité de commande (314) pour commander la fréquence d'oscillation dudit laser à semiconducteur pour conserver ladite fréquence à une valeur donnée en utilisant ledit second signal de sortie en tant que signal représentant une erreur dans ladite fréquence d'oscillation.

9. Source de lumière à fréquence stabilisée selon la revendication 8, dans laquelle ladite fréquence d'oscillation dudit laser à semiconducteur (301) est commandée en fonction de la fréquence de crête dudit résonateur optique (304).

10. Source de lumière à fréquence stabilisée selon la revendication 8, dans laquelle ledit laser à semiconducteur (301) est monté sur un premier puits de chaleur (312) et est commandé pour avoir une température constante, et dans laquelle ledit résonateur optique (304) est monté sur un second puits de chaleur (307) et ladite température dudit résonateur optique (304) est modulée par l'intermédiaire dudit second puits de chaleur (307).

11. Source de lumière à fréquence stabilisée selon la revendication 8, dans laquelle le courant de pilotage pour ledit laser à semiconducteur (301) est commandé de sorte qu'une puissance de lumière de sortie en provenance dudit laser (301) est conservée constante.

12. Source de lumière à fréquence stabilisée selon la revendication 8, dans laquelle la température dudit laser à semiconducteur (301) est commandée de sorte qu'une puissance de lumière de sortie en provenance dudit laser (301) est conservée constante.

13. Source de lumière à fréquence stabilisée selon la revendication 8, dans laquelle le courant de pilotage pour ledit laser à semiconducteur (301) est commandé de sorte que ladite fréquence d'oscillation dudit laser (301) est conservée à une valeur donnée.

14. Source de lumière à fréquence stabilisée selon la revendication 8, dans laquelle la température dudit laser à semiconducteur (301) est commandée de sorte que ladite fréquence d'oscillation dudit laser (301) est conservée à une valeur donnée.

15. Module laser à semiconducteur comprenant :

   un premier puits de chaleur (312) dont la température peut être commandée ;
   un laser à semiconducteur (301) monté sur ledit premier puits de chaleur (312) ;
   ledit laser à semiconducteur (301) émettant un faisceau de lumière de sortie ;
   une source de signal de modulation (311) émettant un signal de modulation ;
   un second puits de chaleur (307) dont la température est modulée par ledit signal de modulation ;
   un résonateur optique (304) monté sur ledit second puits de chaleur (307) ;
   ledit faisceau de lumière de sortie étant injecté dans ledit résonateur optique pour émettre un faisceau de lumière transmis en provenance dudit résonateur optique (304) ;
   un détecteur (305) pour recevoir ledit faisceau de lumière transmis pour détecter la puissance dudit faisceau de lumière transmis ; et
   un boîtier (501) pour incorporer ledit premier puits de chaleur, ledit laser à semiconducteur, ledit second puits de chaleur, ledit résonateur optique et ledit détecteur.

16. Module laser à semiconducteur selon la revendication 15, dans lequel la température dudit résonateur optique (304) est modulée par ledit signal de modulation ;

le faisceau de lumière transmis à travers ledit résonateur optique (304) est utilisé pour produire un premier signal de sortie ;
la puissance dudit faisceau de lumière transmis est commandée pour être conservée constante sur la base dudit premier signal de sortie ;
ledit premier signal de sortie est détecté de façon synchrone avec ladite fréquence de modulation pour produire un second signal de sortie ; et
la fréquence d'oscillation dudit laser à semiconducteur (301) est commandée pour conserver ladite fréquence à une valeur donnée en utilisant ledit second signal de sortie en tant que signal représentant une erreur dans ladite fréquence d'oscillation.

17. Module laser à semiconducteur selon la revendication 16, dans lequel ladite fréquence d'oscillation dudit laser à semiconducteur (301) est commandée en fonction d'une fréquence de crête dudit résonateur optique (304) dans ladite étape de commande de fréquence d'oscillation.

18. Module laser à semiconducteur selon la revendication 15, dans lequel ledit laser à semiconducteur (301) est commandé pour avoir une température constante par l'intermédiaire dudit premier puits de chaleur (312) et ledit résonateur optique (304) est modulé par l'intermédiaire dudit second puits de chaleur (307).

# F I G. 1

POWER SUPPLY
709

PID
CONTROLLER
707

703 OSCILLATOR

LASER
701

LOCK-IN AMP.

706

702 TEMP.
CONTROLLER

708
LENS

704
GAS CELL

705
DETECTOR

# F I G. 2

803 LASER

THERMOSTATIC
BATH
801

$V_F$

+

−

TEMP.
CONT.

802
PELTIER
ELEMENT

805
DIF. AMP.

806

804
CURRENT
SOURCE

# F I G. 3

# F I G. 3A

# F I G. 4

# F I G. 5

406
CURRENT CONTROLLER P

I

OPTICAL FIBER 303

LENS 302

LASER 301

RESONATOR 304

312

305
DET.

501 CASING

HEAT SINK

313 TEMP. DET.

HEAT SINK

308 TEMP. DET.

307

315 PELTIER ELEMENT

317

310 PELTIER ELEMENT

$T_1$

314
TEMP. CONTROLLER

$f_m$

311

$f_m$

309
TEMP. CONTROLLER

$T_2$

$\triangle f$

P

316 SYNCHRONOUS DETECTOR

# F I G. 6

# F I G. 7